# EUROPEAN PATENT APPLICATION

(11) **EP 4 836 608 A1**
(43) Date of publication of application: **04.11.2026**
(21) Application number: 25172957.0
(22) Date of filing: 28.04.2025
(51) Int. Cl.: H05K 5/06

(54) **A CABLE SEALING ASSEMBLY, A HOUSING OF AN ELECTRONICAL DEVICE AND USE OF SUCH ASSEMBLY**

(71) Applicant: Axis AB, 223 69 Lund (SE)
(72) Inventor: Radnic, Tomá, 143 01 Prague (CZ)
(74) Representative: AWA Sweden AB

(57) **Abstract**

A cable sealing assembly (1000) to be used in a housing (500) of an electronical device is provided. The assembly comprises a first sealing block (100) and a second sealing block (200), each sealing block comprising an elongated cable receiving groove (101; 201). The sealing blocks are configured to be arranged to sealingly abut each other whereby the two cable receiving grooves (101; 201) together define a cable receiving channel (300). The cable receiving groove in the first sealing block comprises a recess (103) that is arranged in a position between the two open ends (102A, 102B) of the groove. The cable receiving groove in the second sealing block is arranged in a ridge (230) that is formed in the second sealing block. The ridge supports a flexible protrusion (203) that is arranged in a position between the two open ends (202A, 202B) of the groove and aligned with the recess in the first sealing block. The ridge is configured to be received in the cable receiving groove in the first sealing block as seen in a condition the first and sealing blocks are arranged to abut each other. The protrusion is movable in and out of engagement with the recess as seen in a condition when the first and second sealing blocks are arranged to abut each other. Also, a housing using such assembly is provided.

## Description

### Technical field

The present invention refers to a cable sealing assembly to be used in a housing of an electronical device, a housing of an electronical device using such sealing assembly, and also to the use of such sealing assembly to seal a cable receiving opening in a housing of an electronical device.

### Technical background

Sealing of the housing of an electronic device is crucial for protecting its internal components from environmental factors such as moisture, dust, and temperature variations. The sealing is often made as a gasket that is arranged in an interface between two housing parts to thereby sealingly abut opposing wall surfaces when the housing parts are assembled.

It is however more crucial to seal-off a cable receiving opening in the housing since this requires that the housing is provided with a through-going opening in one of its wall portions. A typical example of such opening is an opening that allows receipt of a power cable that should be connected to the electronic device inside the housing. Such opening is often preformed in the housing to facilitate the installation on site. This kind of opening can be provided with a flexible sealing that encircles the circumference of the opening and which sealingly engages the cable when the cable is mounted.

There is however a problem if the housing should be provided with an additional opening that allows the electronic device to be connected with an auxiliary cable at the fitters choice. Such additional opening must be provided with a closure that completely closes off the opening until it is decided that the opening should be used. Should it be used, it must also be provided with a sealing that matches the cross section of the auxiliary cable.

There is hence a need to provide a sealing assembly that facilitates the work of the fitter and which ensures a required sealing effect, no matter if the auxiliary cable-receiving opening receives a cable or not.

### Summary

It is an object of the present invention to provide a sealing assembly that is easy to mount in a housing.

The sealing assembly should seal off a cable receiving opening in the housing, no matter if a cable is mounted in the cable receiving opening or not.

Another object is to provide a sealing assembly that is fail-proof in the sense that the sealing effect is automatically achieved when two housing parts are assembled.

Yet another object is to provide a sealing assembly that can be provided premounted in the housing.

These and other objects that will be apparent from the following summary and description are achieved by a cable sealing assembly to be used in a housing of an electronical device, the assembly comprising:
a first sealing block and a second sealing block, each sealing block comprising an elongated cable receiving groove having two opposing open ends,
the first and second sealing blocks being configured to be arranged to sealingly abut each other whereby the two cable receiving grooves together define a cable receiving channel having an inlet opening and an outlet opening, wherein
the cable receiving groove in the first sealing block comprises a recess that is arranged in a position between the two open ends,
the cable receiving groove in the second sealing block is arranged in a ridge that is formed in the second sealing block, and said ridge supports a flexible protrusion that is arranged in a position between the two open ends and aligned with the recess in the first sealing block, wherein the ridge is configured to be received in the cable receiving groove in the first sealing block as seen in a condition the first and sealing blocks are arranged to abut each other, whereby
the protrusion, as seen in a condition when the first and second sealing blocks are arranged to abut each other, is movable in and out of engagement with the recess.

Accordingly, the invention provides a sealing assembly that comprises two sealing blocks, one having a recess and one having a flexible protrusion that is aligned with the recess. The protrusion is supported by the ridge. The ridge has a length along the longitudinal direction of the cable receiving groove that exceeds the length of the protrusion. It is preferred that the ridge has a length that corresponds to the full length of the cable receiving groove of the second sealing block.

The ridge together with the flexible protrusion will provide a complete sealing-off of the cable receiving channel that is formed when the first and second sealing blocks are arranged to abut each other.

In a condition when no cable is arranged to extend through the cable receiving channel, the flexible protrusion is received in the recess. The sealing effect is automatically achieved when assembling the first and second housing parts, where the first housing part contains the first sealing block and the second housing part contains the second sealing block. This sealing effect can be seen as a default position that is automatically achieved as long as no cable is arranged through the cable receiving channel. This sealing effect is also automatically restored should the cable be removed.

When a fitter dis-connects the two housing parts, arranges a cable along the cable receiving groove in one of the two sealing blocks, and re-connects the two housing parts, the cable will prevent the flexible protrusion from engaging the recess, whereby the protrusion and the ridge instead will sealingly abut the cable. Hence, the flexible protrusion together with the envelope walls of the cable receiving groove of the second sealing block will sealingly abut one portion of the cable, while the envelope walls of the cable receiving groove extending on opposite sides of the recess in the first sealing block will sealingly abut the opposite portion of the envelope wall of the cable. Thereby, the interface between the envelope wall portions that define the cable receiving channel and the envelope wall of the cable will automatically be sealed. The protrusion will hence act as sealing no matter if the housing is connected to a cable or not. Also, the fitter does not have to actively handle any separate sealing member, which saves time and ensures a high-qualitative fitting.

The ridge may comprise longitudinally extending side walls, said side walls being configured to abut complementary longitudinally extending side walls in the cable receiving groove in the first sealing block as seen in a condition when the first and second sealing blocks are arranged to abut each other.

The flexible protrusion may be configured to engage the recess and thereby at least partly close off the cable receiving channel as seen in a condition when no cable is arranged along the cable receiving channel.

The ridge and the flexible protrusion together with a cable are configured to close off the cable receiving channel as seen in a condition when a cable is arranged along the cable receiving channel, said cable being configured to force the flexible protrusion out of engagement with the recess.

A width as measured between the longitudinally extending side walls of the ridge and transverse the longitudinal direction of the cable receiving groove in the second sealing block may equal a width as measured between the complementary longitudinally extending side walls in the cable receiving groove in the first sealing block.

A width of the recess may equal a width of the protrusion as measured transverse the longitudinal direction of the cable receiving grooves in the first and second sealing blocks. Alternatively, or in addition, a length of the recess may equal a length of the protrusion as measured along the longitudinal direction of the cable receiving grooves in the first and second sealing blocks.

The recess may have a cross section being an inversion of the cross section of the protrusion, as seen along the longitudinal direction of the cable receiving grooves or as seen in a direction transverse the longitudinal direction of the cable receiving grooves.

The recess and the flexible protrusion may each have the shape of a cuboid.

An envelope wall of the cable receiving groove in the first sealing block may comprise one or more cable receiving sub-grooves, said one or more sub-grooves having a first elongated portion extending from one of the two opposing ends of the cable receiving groove to the recess and a second elongated portion extending from the recess to the other of the two opposing ends of the cable receiving groove. The sub-grooves may extend in parallel and coincide with the longitudinal direction of the cable receiving groove.

In the event of two or more sub-grooves, the two sub-grooves may be separated by an elongated ridge. The provision of sub-grooves is useful in the event a cable to be connected to the electronical device is of a twin cable type, with two cables contained in a respective sheath. The ridge may also act as a seal against a common sheath.

An envelope wall of the cable receiving groove in the second sealing block may comprise one or more cable receiving sub-grooves, said one or more sub-grooves having a first elongated portion extending from one of the two opposing ends of the cable receiving groove to the protrusion, a second elongated portion extending along the protrusion, and a third elongated portion extending from the protrusion to the other of the two opposing ends of the cable receiving groove. In the event of two or more sub-grooves, the two sub-grooves may be separated by an elongated ridge. The provision of sub-grooves is useful in the event a cable to be connected to the electronical device is of a twin cable type, with two cables contained in a respective sheath. The ridge may also act as a seal against a common sheath.

The protrusion may, in a wall portion thereof facing away from the cable receiving groove, comprise a cavity, said cavity allowing the protrusion to flex in a direction away from the cable receiving groove. The cavity may be seen as a local weakening of the protrusion that acts as a deformation zone to thereby facilitate the protrusion's ability to conform to the shape of the cable. The skilled person realizes that the cavity may be provided as a void or a recess and may have a number of different shapes with remained functionality. The cavity may be omitted if the sealing material that is used has an inherent capability to be compressed if exerted to pressure.

Parallel grooves may extend along opposing sides of the flexible protrusion. The grooves act as a local weakening that further improves the flexible protrusion's ability to conform to the shape of a cable.

The longitudinally extending sides walls of the ridge of the second sealing block may each comprise at least one protrusion extending in a direction transverse the longitudinal direction of the cable receiving groove in the second sealing block, and the longitudinally extending side walls in the cable receiving groove in the first sealing block may each comprise at least one complementary indent extending in a direction transverse the longitudinal direction of the cable receiving groove in the first sealing block.

Alternatively, the longitudinally extending sides walls of the ridge of the second sealing block may each comprise at least one indent extending in a direction transverse the longitudinal direction of the cable receiving groove in the second sealing block, and the longitudinally extending side walls in the cable receiving groove in the first sealing block may each comprise at least one complementary protrusion extending in a direction transverse the longitudinal direction of the cable receiving groove in the first sealing block.

The provision of an indent and a mating protrusion provides a supplementary sealing effect that acts between abutting surfaces of the first and second sealing blocks. The indent and protrusion do preferably have a complementary shape.

The first and second sealing blocks may be formed by a hyper elastic material or by an elastomer. Hyper elasticity is a non-linear elastic material model theory that is commonly used to represent the large-strain response of elastomers and rubbers. Non-limiting examples of suitable materials are silicon and rubber. As a non-limiting example of an elastomer, EPDM (ethylene propylene diene monomer rubber) is provided. No matter type of material, it is preferred that the material is incompressible or close to being incompressible. The first and second sealing blocks may be formed by a single material or be a combination of two or more materials. Two or more materials may be co-moulded. Also, two or more rubber-based materials may be vulcanized.

At least one of the first and second sealing blocks may be integrally formed with a sealing bead. The sealing bead may in its opposing ends connect to the first or the second sealing block to thereby form a loop together with the sealing block. The loop is preferably closed. The bead may have an overall longitudinal extension that corresponds to the longitudinal extension of a rim of a housing part. The bead may be configured to be partly received in a rim in one of the two housing parts and sealingly abut two interconnected housing parts.

According to another aspect of the invention, a housing of an electronical device is provided. The housing comprises a first housing part and a second housing part that are arranged in an abutting relationship to thereby form a closed compartment, said housing comprising an opening being defined in an interface between the first and the second housing parts, wherein the first and second housing parts together support a sealing arrangement with the features according to any of claim 1-11, and wherein the opening in the housing is coaxial with the inlet opening and the outlet opening of the cable receiving channel.

The sealing assembly as such with its features and advantages has been thoroughly discussed above, and those arguments are equally applicable to a housing of an electronical device in which such sealing arrangement is arranged.

Especially, by the use of such sealing assembly a sealing-off effect is automatically achieved when assembling the first and second housing parts, where the first housing part contains the first sealing block and the second housing part contains the second sealing block. This sealing-off effect can be seen as a default position that is automatically achieved as long as no cable is connected. This sealing-off effect is also automatically restored should the cable be removed.

When a fitter dis-connects the two housing parts, arranges a cable along the cable receiving groove in one of the sealing blocks, and re-connects the two housing parts, the cable will force the flexible protrusion out of engagement with the recess, whereby the protrusion instead will sealingly abut the cable. Hence, the flexible protrusion together with the envelope wall of the cable receiving groove of the second sealing block that extends on opposite sides of the protrusion will sealingly abut one portion of the envelope wall of the cable, while the envelope wall of the cable receiving groove extending on opposite sides of the recess in the first sealing block will sealingly abut the opposite portion of the envelope wall of the cable. The interface between the envelope wall portions that define the cable receiving channel and the envelope wall of the cable will thereby automatically be sealed. The fitter does not have to actively handle any sealing member, which saves time and ensures a high-qualitative fitting.

The first housing part may comprise a recess receiving the first sealing block in an area adjacent the opening of the housing, and the second housing part may comprise a recess receiving the second sealing block adjacent the opening of the housing, wherein the sealing bead extends along a rim portion of one of the first and second housing parts.

A cable extending from the exterior of the housing into the interior of the housing through the cable receiving channel of the sealing assembly may force the flexible protrusion out of engagement with the recess while the cable is in sealing contact with the one or more cable receiving sub-grooves in the first sealing block and with the one or more cable receiving sub-grooves in the second sealing block.

According to yet another aspect, the invention refers to the use of a cable sealing assembly according to any of claims 1-11 to seal a cable receiving opening in a housing of an electronical device. The sealing assembly as such with its features and advantages has been thoroughly discussed above, and those arguments are equally applicable to the use of such arrangement in a housing of an electronical device.

A further scope of applicability of the present invention will become apparent from the detailed description given below. However, the detailed description and specific examples, while indicating preferred embodiments of the invention, are given by way of illustration only, since various changes and modifications within the scope of the invention will become apparent to those skilled in the art from this detailed description.

Hence, it is to be understood that this invention is not limited to the particular parts of the device described or steps of the methods described as such device and method may vary. It is also to be understood that the terminology used herein is for purpose of describing particular embodiments only and is not intended to be limiting. It must be noted that, as used in the specification and the appended claim, the articles "a," "an, " "the," and "said" are intended to mean that there are one or more of the elements unless the context clearly dictates otherwise. Thus, for example, reference to "a unit" or "the unit" may include several devices, and the like. Furthermore, the words "comprising", "including", "containing" and similar wordings do not exclude other elements or steps.

### Brief description of the drawings

The invention will be described in more detail with reference to the appended schematic drawings, which show examples of a presently preferred embodiment of the invention.
Fig. 1 is a first perspective view of the first and second sealing blocks forming part of the cable sealing assembly.
Fig. 2 is a second perspective view of the first and second sealing blocks forming part of the cable sealing assembly.
Fig. 3A is a top view of the first sealing block.
Fig. 3B is a first side view of the first sealing block.
Fig. 3C is a second side view of the first sealing block.
Fig. 4A is a top view of the second sealing block.
Fig. 4B is a first side view of the second sealing block.
Fig. 4C is a second side view of the second sealing block.
Fig. 5A is a top view of the first and second sealing blocks without any cable.
Fig. 5B is a section cut along line A-A of Fig. 5A of the first and second sealing block without any cable.
Fig. 5C is a section cut along line B-B of Fig. 5A of the first and second sealing blocks without any cable.
Fig. 6 is highly schematic section cut along line B-B of Fig. 5Aof the first and second sealing blocks together with a cable.
Fig. 7A is a highly schematic top view of a first housing part with a first sealing block.
Fig. 7B is a highly schematic top view of a second housing part with a second sealing block.
Fig. 8 is a highly schematic side view of a housing without any cable.
Fig. 9 is a highly schematic side view of a housing with a cable.

### Detailed description

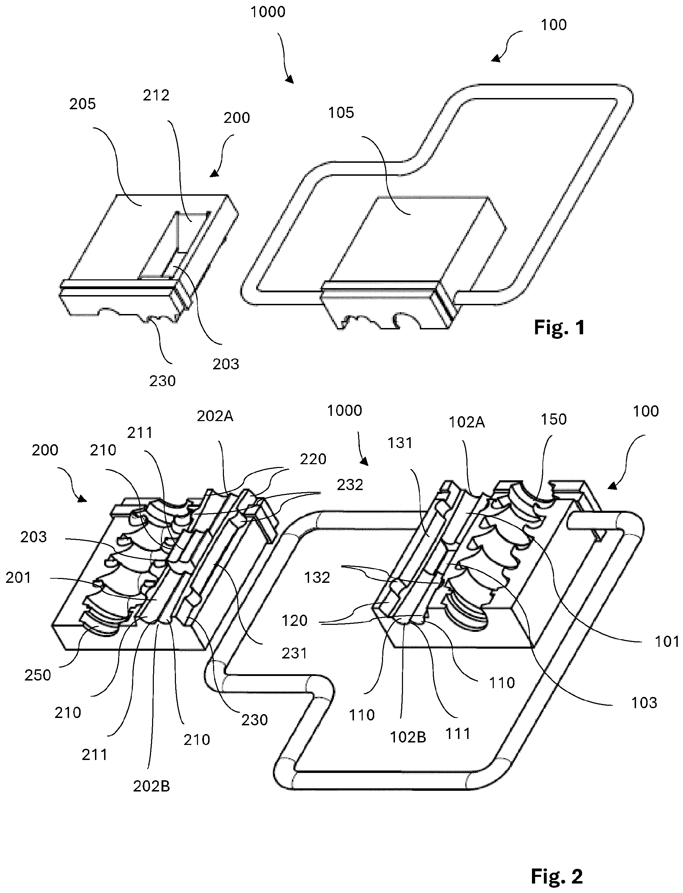

Starting with Figs. 1 and 2. The assembly 1000 comprises a first sealing block 100 and a second sealing block 200. Each sealing block 100, 200 comprises an elongated cable receiving groove 101; 201 having two opposing open ends 102A, 102B; 202A 202B. The first and second sealing blocks 100, 200 are, as will be described below, configured to be arranged to sealingly abut each other whereby the two grooves 101; 201 together define a cable receiving channel having an inlet opening and an outlet opening. The cable receiving channel will be further described below.

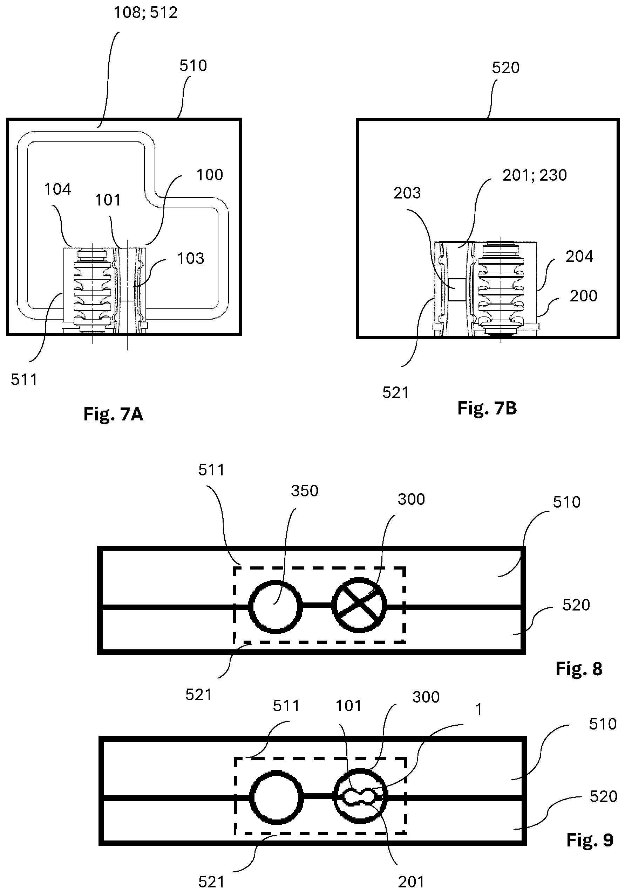

The first and second sealing blocks 100, 200 do further each comprise an additional cable receiving groove 150, 250. These additional grooves 150, 250 are together configured to define an additional cable receiving channel 350 as will be briefly discussed below with reference to Figs. 8 and 9.

The cable receiving groove 101 in the first sealing block 100 comprises a recess 103 that is arranged in a position between the two open ends 102A, 102B. The cable receiving groove 201 in the second sealing block 200 is arranged in a ridge 230 that is formed in the second sealing block 200. The ridge 230 may also be referred to as a bead or a shoulder.

The ridge 230 supports a flexible protrusion 203 that is arranged in a position between the two open ends 202A, 202B and aligned with the recess 103 in the first sealing block 100. The ridge 230 is configured to be received in the cable receiving groove 101 in the first sealing block 100 as seen in a condition the first and sealing blocks 100, 200 are arranged to abut each other. The flexible protrusion 203 is, as will be discussed below, movable in and out of engagement with the recess 103 as seen in a condition when the first and second sealing blocks 100, 200 are arranged to abut each other.

The first and second sealing blocks 100, 200 may be formed by a hyper elastic material or an elastomer. Hyper elasticity is a non-linear elastic material model theory that is commonly used to represent the large-strain response of elastomers and rubbers. Non-limiting examples of suitable materials are silicon and rubber. As a non-limiting example of an elastomer, EPDM (ethylene propylene diene monomer rubber) is provided. No matter type of material, it is preferred that the material is incompressible or close to being incompressible. The first and second sealing blocks 100, 200 may be formed by a single material or be a combination of two or more materials. Two or more materials may be co-moulded. Also, two or more rubber-based materials may be vulcanized. The skilled person also realizes that the first and second sealing blocks 100, 200 do not have to be made of the same material.

In the following, the design of the first and second sealing blocks will be described. The two sealing blocks will be described as lying flat on a fictive horizontal surface. The terms upper and lower will be used, where *"lower"* refers to a position closest to the horizontal fictive surface and *"upper"* refers to a position further away from said horizontal fictive surface along a normal. The skilled person does however realize that the assembly upon use can have any spatial orientation.

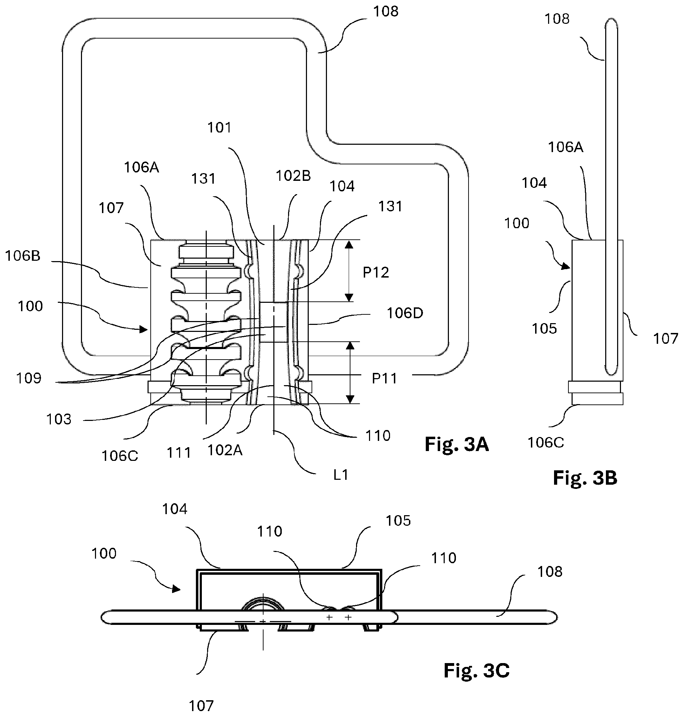

Now turning to Figs 3A-3C, the first sealing block 100 will be discussed. The first sealing block 100 comprises a block-shaped body 104. The body 104 is shown as having a substantially rectangular geometry. It is understood that the body 104 with remained functionality may have other shapes. The body 104 comprises a substantially flat lower wall 105 that in use is configured to face a wall portion in a first housing part (omitted). The lower wall 105 connects to four side walls 106A-106D, which in turn connect to an upper wall 107. The walls do together define a solid or substantially solid volume of the body 104.

The first sealing block 100 is integrally formed with a sealing bead 108. The sealing bead 108 connects via its opposing ends to two opposing side walls 106B, 106D of the body 104 to thereby form a loop. The loop is preferably closed. The bead 108 may have an overall longitudinal extension that corresponds to the longitudinal extension of a rim of the intended housing part (omitted). The bead 108 may be configured to be at least partly received in a rim in one or both of the two housing parts (omitted). The bead 108 will thereby sealingly abut two interconnected housing parts.

The upper wall 107 of the first sealing block 100 is provided with the elongated cable receiving groove 101 that has two opposing open ends 102A, 102B. The cable receiving groove 101 extends between the two of the opposing side walls 106A, 106C. The groove 101 is disclosed as having a straight-linear extension along the longitudinal direction of the groove 101. The two open ends 102A, 102B are disclosed as having the same geometries. Different geometries may be applicable.

A central portion of the cable receiving groove comprises the recess 103. The recess 103 is disclosed as having the shape of a cuboid. The recess 103 has two parallel elongated side walls that extend on opposite sides of the longitudinal centreline L1 of the cable receiving groove 101. The recess 103 is preferably symmetrically arranged in view of the centreline L1.

The cable receiving groove 101 is preferably provided with straight-linear side walls 109 that extend along a portion of the longitudinal direction the cable receiving groove 101. The straight-linear side walls of the groove preferably extend along at least a portion of the length of the recess 103. The straight-linear side walls 109 are preferably parallel.

The recess 103 with its straight-linear side walls 109 can be seen as forming a waist portion of the cable receiving groove 101. The recess 103 may have the shape of a cuboid.

The recess 103 may have a cross section being an inversion of the cross section of the flexible protrusion 203 in the second sealing block 200, as seen along the longitudinal direction of the cable receiving grooves 101, 201 or as seen in a direction transverse the longitudinal direction of the cable receiving grooves.

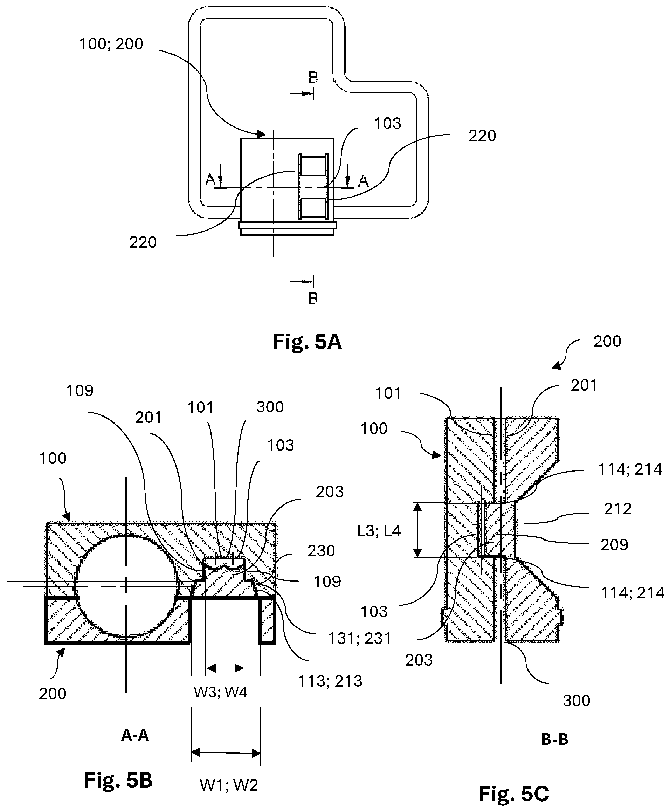

The geometry of the recess 103 will be further discussed below with reference to Figs. 5B and 5C.

An envelope wall of the cable receiving groove 101 in the first sealing block 100 comprises, best seen in Figs. 2 and 3A two cable receiving sub-grooves 110. The sub-grooves are separated by an elongated ridge 111.

The sub-grooves 110 have a first elongated portion P11 extending from one of the two opposing ends 102A of the cable receiving groove 101 to the recess 103 and a second elongated portion P12 extending from the recess 103 to the other of the two opposing ends 102B of the cable receiving groove 101. The sub-grooves 110 extend in parallel and coincide with the longitudinal direction L1 of the cable receiving groove 101.

The two sub-grooves 110 are configured to correspond to an outer contour of the outer envelope wall of a twin cable, i.e. a cable type which as such is well known in the art where two cables are contained side by side in a respective sheath. These sheaths may be received in a common cable sheath. The ridge 111 that separates the two sub-grooves 110 is configured to be received between two respective sheaths or abut one side of the common cable sheath. The skilled person realizes that the cross section of the envelope wall of the cable receiving groove 101 may be adapted to the intended cross section of the cable to be received in the groove. The envelope wall of the cable receiving groove 101 may by way of example have a strict half-circular cross section in the event of a circular cable or have two or more sub-grooves in the event of a twin cable.

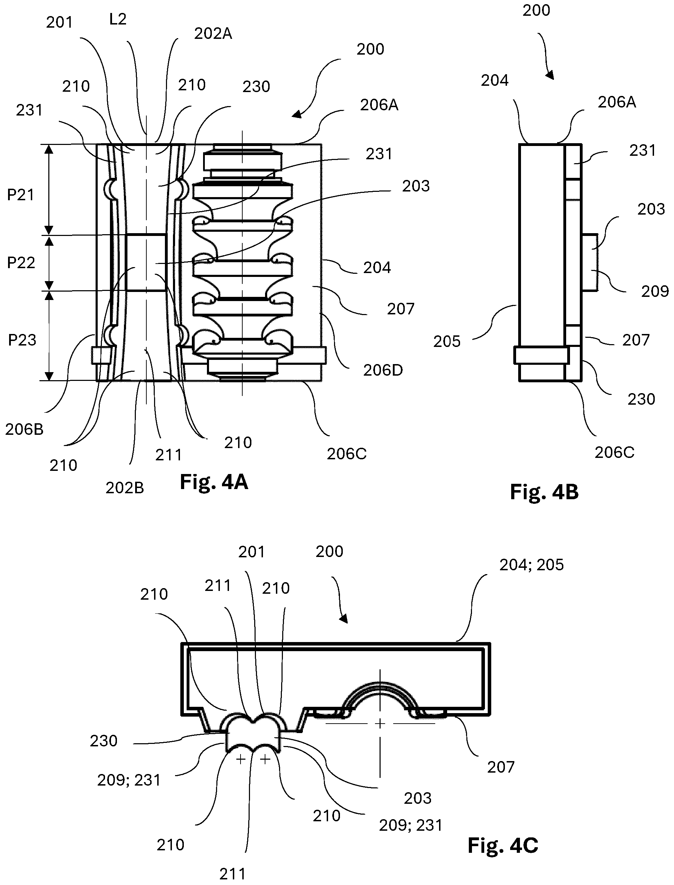

Now turning to Figs 4A-4C, the second sealing block 200 will be discussed. The second sealing block 200 comprises a block-shaped body 204. The body 204 is shown as having a substantially rectangular geometry. It is understood that the body 204 with remained functionality may have other shapes. The body 204 comprises a lower, substantially flat wall 205 that is configured to face a wall portion in a second housing part (omitted). The lower wall 205 connects to four side walls 206A-206D, which in turn connect to an upper wall 207.

The upper wall 207 is provided with a ridge 230. An upper surface of the ridge 230 supports the elongated cable receiving groove 201. The groove 201 has two opposing open ends 202A, 202B. The cable receiving groove 201 extends between two of the opposing side walls 206A, 206C. The groove 201 is disclosed as having a straight-linear extension along the longitudinal direction L2 of the groove 201. The two open ends 202A, 202B are disclosed as having the same geometries. Different geometries may be applicable. The geometry is preferably the same as that of the two open ends in the block of the first sealing block.

The ridge 230 has a length along the longitudinal direction L2 of the cable receiving groove 201 that exceeds a length of the protrusion 203. It is preferred that the ridge 230 has a length that corresponds to the full length of the cable receiving groove 201 of the second sealing block 200.

The ridge 230 comprises longitudinally extending side walls 231. The side walls 231 are configured to abut complementary longitudinally extending side walls 131 in the cable receiving groove 101 in the first sealing block 100 as seen in a condition when the first and second sealing blocks are arranged to abut each other.

A central portion of the ridge 230 supports the flexible protrusion 203. The protrusion 203 is disclosed as having the shape of a cuboid. The protrusion 203 has two parallel elongated side walls 209 that extend on opposite sides of the longitudinal centreline L2 of the cable receiving groove 202. The side walls 209 are disclosed as being straight-linear.

An envelope wall of the cable receiving groove 201 in the second sealing block 200 comprises, best seen in Figs. 2, 4A, and 4C two cable receiving sub-grooves 210. The sub-grooves 210 are separated by an elongated ridge 211. The sub-grooves 210 have a first elongated portion P21 extending from one of the two opposing ends 202A of the cable receiving groove 201 to the protrusion 203, a second elongated portion P22 extending along the protrusion 203, and a third elongated portion P23 extending from the protrusion 203 to the other of the two opposing ends 202B of the cable receiving groove 201. The sub-grooves 210 extend in parallel and coincide with the longitudinal direction L2 of the cable receiving groove 201. The two sub-grooves 210 are configured to correspond to an outer contour of the outer envelope wall of a twin cable. The ridge 211 that separates the two sub-grooves 210 is, depending on the type of cable, configured to be received between two sheaths or abut a common sheath.

The skilled person realizes that the cross section of the envelope wall of the cable receiving groove 201 may be adapted to the intended cross section of the cable to be received in the groove. The envelope wall of the cable receiving groove 201 may by way of example have a half-circular cross section in the event of a circular cable or have two or more sub-grooves.

Now turning to Fig. 1. A rear side of the flexible protrusion 203, i.e. a wall portion thereof facing away from the cable receiving groove 201, may comprise a cavity 212. The cavity 212 may be seen as a local weakening that acts as a deformation zone to thereby facilitate the flexible protrusion's 203 ability to conform to the shape of a cable. The skilled person realizes that the cavity 212 may be provided as a void or as a recess and may have a number of different shapes with remained functionality. The cavity 212 may be omitted if the sealing material that is used has an inherent capability to be compressed if exerted to pressure.

To further improve the flexible protrusion's 203 ability to conform to the shape of a cable, a further local weakening may be arranged along opposing sides of the protrusion 203. This is best seen in Fig. 5A which discloses two parallel grooves 220 that extend along the opposing sides of the protrusion 203.

Now turning to Fig 2. The longitudinally extending sides walls 231 of the ridge 230 do each comprise at least one protrusion 232 that extends in a direction transverse the longitudinal direction of the cable receiving groove 201 in the second sealing block 200. The ridge 230 is disclosed as comprising four protrusions 232. Correspondingly, the longitudinally extending side walls 131 in the cable receiving groove 101 in the first sealing block 100 do each comprise at least one complementary indent 132 that extends in a direction transverse the longitudinal direction of the cable receiving groove 101 in the first sealing block 100. The side wall 131 is disclosed as comprising four indents 132.

The skilled person realises that the positions of the indents 132 and the protrusions 232 may be changed with remained functionality. Hence, the elongated sealing surfaces in the first block may each comprise at least one protrusion extending in a direction transverse the longitudinal direction of the cable receiving grooves, and the elongated sealing surfaces in the second block may each comprise at least one complementary indent extending in a direction transverse the longitudinal direction of the cable receiving grooves.

The provision of indents 132 and mating protrusions 232 provide a supplementary sealing effect that acts between abutting surfaces of the first and second sealing blocks 100, 200 in a condition when the first and second sealing blocks are moved into an abutting condition. The indents 132 and protrusions 232 do preferably have a complementary shape.

Now turning to Figs. 5A-5C. Fig. 5A discloses a condition when the first and second blocks 100, 200 have been moved into engagement with each other without any intermediary cable. Fig. 5B is a section cut as taken along line A-A, i.e. transverse the longitudinal directions of the first and second cable receiving grooves 101, 102. The section cut A-A is also taken along the waist that is formed by the recess 103. Correspondingly, Fig. 5C is a section cut as taken along line B-B, i.e. along the longitudinal centrelines of the first and second cable receiving grooves 101, 102.

Starting with Fig. 5B. A width W2 as measured between the longitudinally extending side walls 231 of the ridge 230, transverse the longitudinal direction of the cable receiving groove 201 of the second sealing block 200 and in a position along the protrusion 203, equals a width W1 as measured between the complementary longitudinally extending side walls 131 in the cable receiving groove 101 in the first sealing block 100.

A width W3 of the recess 103 equals a width W4 of the protrusion 203 as measured transverse the longitudinal direction of the cable receiving grooves 101, 201 in the first and second sealing blocks 100, 200 and in a position along the recess 103 and the protrusion 203.

The ridge 230 together with the flexible protrusion 203 will thereby provide a complete sealing off-of the cable receiving channel 300 that is formed along the longitudinal extension of the recess 103 and the protrusion 203 when the first and second sealing blocks 100, 200 are arranged to abut each other. The complete sealing-off effect is automatically achieved when assembling the first and second housing parts 100, 200 in a condition when no cable is arranged to extend through the cable receiving channel 300. This sealing-off effect can be seen as a default position that is automatically achieved as long as no cable is arranged through the cable receiving channel. This sealing-off effect is also automatically restored should a mounted cable be removed.

Turning to Fig. 5C. A length L3 of the recess 103 may equal a length L4 of the protrusion 203 as measured along the longitudinal direction of the cable receiving grooves 101, 201 in the first and second sealing blocks 100, 200.

The recess 103 may have a cross section being an inversion of the cross section of the flexible protrusion 203, as seen along the longitudinal direction of the cable receiving grooves 101, 201 or as seen in a direction transverse the longitudinal direction of the cable receiving grooves 101, 201. The recess 103 and the flexible protrusion 203 may each have the shape of a cuboid.

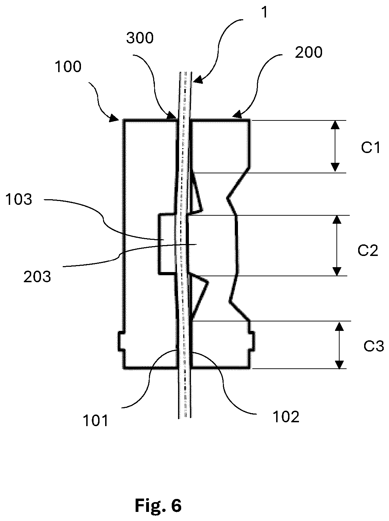

Now turning to Fig. 6 which represents a situation where the first and second sealing blocks 100, 200 have been moved into an abutting relation with a cable 1 extending through the resulting cable receiving channel 300. Fig. 6 is a section cut taken along B-B in Fig. 5A.

When a fitter dis-connects the two housing parts (omitted), arranges a cable 1 along the cable receiving grooves 101, 201, and re-connects the two housing parts, the cable 1 will force the flexible protrusion 203 out of engagement with the recess 103, whereby the protrusion 203 instead will sealingly abut the cable 1. Hence, the flexible protrusion 203 will sealingly abut one portion of the envelope wall of the cable C2, while the envelope walls of the cable receiving grooves 101, 201 extending on opposite sides of the recess 103 and the protrusion 203 will sealingly abut the cable along portions C1 and C3. The interface between the envelope wall portions that define the cable receiving channel 300 and the envelope wall of the cable 1 will automatically be sealed-off. The housing will accordingly be sealed-off no matter if the housing is connected to a cable or not. Also, the fitter does not have to actively handle any separate sealing member, which saves time and ensures a high-qualitative fitting.

Now turning to Figs. 7A and 7B which highly schematically disclose a first housing part 510 and a second housing part 520. The first housing part 510 supports a first sealing block 100 and the second housing part 520 supports a second sealing block 200. The respective bodies 104, 204 of the first and second sealing blocks 100, 200 are arranged in a respective recess 511, 521. The bead 108 of the first sealing block 100 is at least partly received in a corresponding recess 512 in the first sealing block 100. The two housing parts are configured to be arranged in an abutting relationship, see Figs. 8 and 9, to thereby form a closed compartment of a housing 500 of an electronic device. A cable receiving channel 300 is formed by the channel receiving grooves 101, 202.

Turning to Fig. 8. Since no cable is arranged in the cable receiving channel 300, this opening will be automatically sealed-off as a result of the protrusion 203 and ridge 230 in the second sealing block 200 being received in the recess 103 and the first cable receiving groove 101 in the first sealing block 100 as has been described above with reference to Figs. 5A-5C. The complete sealing-off is highly schematically disclosed by a cross. The power cable opening 350 is disclosed as being open.

Now turning to Fig. 9. Should a fitter dis-connect the two housing parts 510, 520, arrange a cable 1 along the cable receiving channel 101 in the first sealing block 100, and reconnect the two housing parts 510, 520, the cable 1 will force the flexible protrusion 203 out of engagement with the recess 103, whereby the protrusion 203 instead will sealingly abut the cable 1. This has previously been described with reference to Fig. 6. Hence, the flexible protrusion 203 of the second sealing block 200 will sealingly abut one portion of the cable 1, while the envelope walls of the cable receiving grooves 101, 201 extending on opposite sides of the recess 103 and the protrusion 203 will sealingly abut the cable 1. The interface between the cable receiving grooves 101, 201 and the cable 1 will automatically be sealed-off.

## Claims

1. A cable sealing assembly (1000) to be used in a housing (500) of an electronical device, the assembly comprising: a first sealing block (100) and a second sealing block (200), each sealing block comprising an elongated cable receiving groove (101; 201) having two opposing open ends (102A, 102B; 202A, 202B),
the first and second sealing blocks (100; 200) being configured to be arranged to sealingly abut each other whereby the two cable receiving grooves (101; 201) together define a cable receiving channel (300) having an inlet opening and an outlet opening, wherein
the cable receiving groove (101) in the first sealing block (100) comprises a recess (103) that is arranged in a position between the two open ends (102A, 102B),
the cable receiving groove (102) in the second sealing block (200) is arranged in a ridge (230) that is formed in the second sealing block (200), and said ridge (230) supports a flexible protrusion (203) that is arranged in a position between the two open ends (202A, 202B) and aligned with the recess (103) in the first sealing block (100), wherein the ridge (230) is configured to be received in the cable receiving groove (101) in the first sealing block (100) as seen in a condition the first and sealing blocks (100, 200) are arranged to abut each other, whereby
the protrusion (203), as seen in a condition when the first and second sealing blocks (100, 200) are arranged to abut each other, is movable in and out of engagement with the recess (103).

2. The cable sealing assembly according to claim 1, wherein the ridge (230) comprises longitudinally extending side walls (231), said side walls (231) being configured to abut complementary longitudinally extending side walls (131) in the cable receiving groove (101) in the first sealing block (100) as seen in a condition when the first and second sealing blocks (100, 200) are arranged to abut each other.

3. The cable receiving assembly according to claim 1 or 2, wherein the flexible protrusion (203) is configured to engage the recess (103) and thereby at least partly close-off the cable receiving channel (300) as seen in a condition when no cable is arranged along the cable receiving channel; and
wherein the ridge (230) and the flexible protrusion (203) together with a cable are configured to close-off the cable receiving channel (300) as seen in a condition when a cable is arranged along the cable receiving channel, said cable being configured to force the flexible protrusion (203) out of engagement with the recess (103).

4. The cable sealing assembly according to claim 3, wherein a width W2 as measured between the longitudinally extending side walls (231) of the ridge (230) and transverse the longitudinal direction of the cable receiving groove (201) in the second sealing block (200) equals a width W1 as measured between the complementary longitudinally extending side walls (131) in the cable receiving groove (101) in the first sealing block (100).

5. The cable sealing assembly according to any of the preceding claims, wherein a width W3 of the recess (103) equals a width W4 of the protrusion (203) as measured transverse the longitudinal direction of the cable receiving grooves (101, 201) in the first and second sealing blocks (100, 200); and/or
wherein a length L3 of the recess (103) equals a length L4 of the protrusion (203) as measured along the longitudinal direction of the cable receiving grooves (101, 201) in the first and second sealing blocks (100, 200).

6. The cable sealing assembly according to any of the preceding claims, wherein
an envelope wall of the cable receiving groove (101) in the first sealing block (100) comprises one or more cable receiving sub-grooves (110), said one or more sub-grooves having a first elongated portion (P11) extending from one of the two opposing ends (102A) of the cable receiving groove (101) to the recess (103) and a second elongated portion (P12) extending from the recess (103) to the other of the two opposing ends (102B) of the cable receiving groove (110).

7. The cable sealing assembly according to any of the preceding claims, wherein an envelope wall of the cable receiving groove (202) in the second sealing block (200) comprises one or more cable receiving sub-grooves (210), said one or more sub-grooves having a first elongated portion (P21) extending from one of the two opposing ends (202A) of the cable receiving groove (210) to the protrusion (203), a second elongated portion (P22) extending along the protrusion (203), and a third elongated portion (P23) extending from the protrusion (203) to the other of the two opposing ends (202B) of the cable receiving groove.

8. The cable sealing assembly according to any of the preceding claims, wherein the protrusion (203) in a wall portion thereof facing away from the cable receiving groove (203) comprises a cavity (212), said cavity allowing the protrusion (203) to flex in a direction away from the cable receiving groove (201).

9. The cable sealing assembly according to any of the preceding claims, wherein the longitudinally extending sides walls (231) of the ridge (230) of the second sealing block (200) each comprises at least one protrusion (232) extending in a direction transverse the longitudinal direction of the cable receiving groove (202) in the second sealing block (200), and the longitudinally extending side walls (131) in the cable receiving groove (101) in the first sealing block (100) each comprises at least one complementary indent (132) extending in a direction transverse the longitudinal direction of the cable receiving groove (101) in the first sealing block (100); or
wherein the longitudinally extending sides walls of the ridge (230) of the second sealing block (200) each comprises at least one indent extending in a direction transverse the longitudinal direction of the cable receiving groove (202) in the second sealing block (200), and the longitudinally extending side walls (131) in the cable receiving groove (101) in the first sealing block (100) each comprises at least one complementary protrusion extending in a direction transverse the longitudinal direction of the cable receiving groove (101) in the first sealing block (100).

10. The cable sealing assembly according to any of the preceding claims, wherein the first and second sealing blocks (100, 200) are formed by a hyper elastic material or an elastomer.

11. The cable sealing assembly according to any of the preceding claims, wherein at least one of the first and second sealing blocks (100, 200) is integrally formed with a sealing bead (108).

12. A housing of an electronical device, the housing (500) comprising a first housing (510) part and a second housing part (520) that are arranged in an abutting relationship to thereby form a closed compartment, said housing (500) comprising an opening being defined in an interface between the first and the second housing parts, wherein the first and second housing parts (510, 520) together support a sealing arrangement (1000) with the features according to any of claim 1-11, and wherein the opening in the housing is coaxial with an inlet opening and an outlet opening of the cable receiving channel (300).

13. The housing according to claim 12, wherein the first housing part (510) comprises a recess (511) receiving the first sealing block (100) in an area adjacent the opening of the housing, and the second housing part (520) comprises a recess (521) receiving the second sealing block (200) adjacent the opening of the housing, and wherein the sealing bead (108) extends along a rim portion of one of the first and second housing parts (510, 520).

14. The housing according to claim 12 or 13, wherein a cable (1) extending from the exterior of the housing (500) into the interior of the housing through the cable receiving channel (300) of the sealing assembly (1000) forces the flexible protrusion (203) out of engagement with the recess (103) while the cable is in sealing contact with the one or more cable receiving sub-grooves (110) in the first sealing block (100) and with the one or more cable receiving sub-grooves (210) in the second sealing block (200).

15. Use of a cable sealing assembly according to any of claims 1-11 to seal a cable receiving opening in a housing of an electronical device.

## Amended claims

### Amended claims in accordance with Rule 137(2) EPC.

1. A cable sealing assembly (1000) to be used in a housing (500) of an electronical device, the assembly comprising: a first sealing block (100) and a second sealing block (200), each sealing block comprising an elongated cable receiving groove (101; 201) having two opposing open ends (102A, 102B; 202A, 202B),
the first and second sealing blocks (100; 200) being configured to be arranged to sealingly abut each other whereby the two cable receiving grooves (101; 201) together define a cable receiving channel (300) having an inlet opening and an outlet opening, wherein
the cable receiving groove (101) in the first sealing block (100) comprises a recess (103) that is arranged between the two open ends (102A, 102B),
the cable receiving groove (201) in the second sealing block (200) is arranged along a ridge (230) that is formed in the second sealing block (200), and said ridge (230) supports a flexible protrusion (203) that is arranged in a position between the two open ends (202A, 202B) and aligned with the recess (103) in the first sealing block (100), wherein the ridge (230) is configured to be received in the cable receiving groove (101) in the first sealing block (100) as seen in a condition the first and sealing blocks (100, 200) are arranged to abut each other, and wherein
the flexible protrusion (203), as seen in a condition when the first and second sealing blocks (100, 200) are arranged to abut each other with a cable extending through the resulting cable receiving channel (300), is forced out of engagement with the recess (103) with the flexible protrusion sealingly abutting the cable.

2. The cable sealing assembly according to claim 1, wherein the ridge (230) comprises longitudinally extending side walls (231), said side walls (231) being configured to abut complementary longitudinally extending side walls (131) in the cable receiving groove (101) in the first sealing block (100) as seen in a condition when the first and second sealing blocks (100, 200) are arranged to abut each other.

3. The cable receiving assembly according to claim 1 or 2, wherein the flexible protrusion (203) is configured to engage the recess (103) and thereby at least partly close-off the cable receiving channel (300) as seen in a condition when no cable is arranged along the cable receiving channel; and
wherein the ridge (230) and the flexible protrusion (203) together with a cable are configured to close-off the cable receiving channel (300) as seen in a condition when a cable is arranged along the cable receiving channel, said cable being configured to force the flexible protrusion (203) out of engagement with the recess (103).

4. The cable sealing assembly according to claim 3, wherein a width W2 as measured between the longitudinally extending side walls (231) of the ridge (230) and transverse the longitudinal direction of the cable receiving groove (201) in the second sealing block (200) equals a width W1 as measured between the complementary longitudinally extending side walls (131) in the cable receiving groove (101) in the first sealing block (100).

5. The cable sealing assembly according to any of the preceding claims, wherein a width W3 of the recess (103) equals a width W4 of the protrusion (203) as measured transverse the longitudinal direction of the cable receiving grooves (101, 201) in the first and second sealing blocks (100, 200); and/or
wherein a length L3 of the recess (103) equals a length L4 of the protrusion (203) as measured along the longitudinal direction of the cable receiving grooves (101, 201) in the first and second sealing blocks (100, 200).

6. The cable sealing assembly according to any of the preceding claims, wherein a wall of the cable receiving groove (101) in the first sealing block (100) comprises one or more cable receiving sub-grooves (110), said one or more sub-grooves having a first elongated portion (P11) extending from one of the two opposing ends (102A) of the cable receiving groove (101) to the recess (103) and a second elongated portion (P12) extending from the recess (103) to the other of the two opposing ends (102B) of the cable receiving groove (110).

7. The cable sealing assembly according to any of the preceding claims, wherein a wall of the cable receiving groove (202) in the second sealing block (200) comprises one or more cable receiving sub-grooves (210), said one or more sub-grooves having a first elongated portion (P21) extending from one of the two opposing ends (202A) of the cable receiving groove (210) to the protrusion (203), a second elongated portion (P22) extending along the protrusion (203), and a third elongated portion (P23) extending from the protrusion (203) to the other of the two opposing ends (202B) of the cable receiving groove.

8. The cable sealing assembly according to any of the preceding claims, wherein the protrusion (203) in a wall portion thereof facing away from the cable receiving groove (203) comprises a cavity (212), said cavity allowing the protrusion (203) to flex in a direction away from the cable receiving groove (201).

9. The cable sealing assembly according to any of the preceding claims, wherein the longitudinally extending sides walls (231) of the ridge (230) of the second sealing block (200) each comprises at least one protrusion (232) extending in a direction transverse the longitudinal direction of the cable receiving groove (202) in the second sealing block (200), and the longitudinally extending side walls (131) in the cable receiving groove (101) in the first sealing block (100) each comprises at least one complementary indent (132) extending in a direction transverse the longitudinal direction of the cable receiving groove (101) in the first sealing block (100); or
wherein the longitudinally extending sides walls of the ridge (230) of the second sealing block (200) each comprises at least one indent extending in a direction transverse the longitudinal direction of the cable receiving groove (202) in the second sealing block (200), and the longitudinally extending side walls (131) in the cable receiving groove (101) in the first sealing block (100) each comprises at least one complementary protrusion extending in a direction transverse the longitudinal direction of the cable receiving groove (101) in the first sealing block (100).

10. The cable sealing assembly according to any of the preceding claims, wherein the first and second sealing blocks (100, 200) are formed by a hyper elastic material or an elastomer.

11. The cable sealing assembly according to any of the preceding claims, wherein at least one of the first and second sealing blocks (100, 200) is integrally formed with a sealing bead (108).

12. A housing of an electronical device, the housing (500) comprising a first housing (510) part and a second housing part (520) that are arranged in an abutting relationship to thereby form a closed compartment, said housing (500) comprising an opening being defined in an interface between the first and the second housing parts, wherein the first and second housing parts (510, 520) together support a sealing arrangement (1000) with the features according to any of claim 1-11, and wherein the opening in the housing is coaxial with an inlet opening and an outlet opening of the cable receiving channel (300).

13. The housing according to claim 12, wherein the first housing part (510) comprises a recess (511) receiving the first sealing block (100) in an area adjacent the opening of the housing, and the second housing part (520) comprises a recess (521) receiving the second sealing block (200) adjacent the opening of the housing, and wherein the sealing bead (108) extends along a rim portion of one of the first and second housing parts (510, 520).

14. The housing according to claim 12 or 13, wherein a cable (1) extending from the exterior of the housing (500) into the interior of the housing through the cable receiving channel (300) of the sealing assembly (1000) forces the flexible protrusion (203) out of engagement with the recess (103) while the cable is in sealing contact with the one or more cable receiving sub-grooves (110) in the first sealing block (100) and with the one or more cable receiving sub-grooves (210) in the second sealing block (200).

15. Use of a cable sealing assembly according to any of claims 1-11 to seal a cable receiving opening in a housing of an electronical device.
